# EUROPÄISCHE PATENTANMELDUNG

(11) **EP 1 174 884 A2**
(43) Veröffentlichungstag der Anmeldung: **23.01.2002**
(21) Anmeldenummer: 01115300.4
(22) Anmeldetag: 25.06.2001
(51) Int. Cl.: G11C 29/00

(54) **Adresszähler zur Adressierung von synchronen hochfrequenten Digitalschaltungen, insbesondere Speicherbauelementen**

(30) Priorität: 18.07.2000 DE 10034897
(71) Anmelder: Infineon Technologies AG, 81669 München (DE)
(72) Erfinder: Ernst, Wolfgang, 81541 München (DE); Krause, Gunnar, 81541 München (DE); Kuhn, Justus, 81373 München (DE); Luepke, Jens, 81829 München (DE); Mueller, Jochen, 81825 München (DE); Poechmueller, Peter, 81739 München (DE); Schittenhelm, Michael, 85586 Poing (DE)
(74) Vertreter: Müller . Hoffmann & Partner Patentanwälte

(57) **Zusammenfassung**

Die Erfindung betrifft einen Adresszähler, der in Kombination mit einem vorhandenen zum Test von Digitalschaltungen dienenden Testgerät zur Adressierung von synchronen hochfrequenten Digitalschaltungen, insbesondere von schnellen Speicherbauelementen dadurch verwendet werden kann, dass mit in programmierbaren Offsetregistern (1 - 4) bereitgestellten Adressenoffsetwerten (a, b, c, d) durch eine Multiplexerschaltung (9, 10) und eine Auswahl- und Verknüpfungsschaltung (5 - 8) auf der Basis von vom Testgerät (TE) mit niedriger Frequenz parallel zugeführten Eingangssignalen (15) sehr flexibel sowohl einfache Adresswechsel als auch Adresssprünge mit hoher Taktfrequenz realisiert werden können.

## Beschreibung

Adresszähler zur Adressierung von synchronen hochfrequenten Digitalschaltungen, insbesondere Speicherbauelementen

Die Erfindung betrifft einen Adresszähler in Kombination mit einem Testgerät zur Adressierung und zum Test von synchronen hochfrequenten Digitalschaltungen insbesondere von Speicherbauelementen, der Spalten- und ZeilenAdresssignale mit der Betriebsfrequenz der Digitalschaltung erzeugt.

Beim Produktionstest hochfrequenter Digitalschaltungen wird ein Adresszähler benötigt, der die beim Test notwendigen Spalten- und Zeilenadressen erzeugt. Um die Funktionalität der zu testenden Digitalschaltung zu testen und fehlerhafte Schaltungen während der Produktion auszuscheiden, müssen die Adresssignale mit der hohen Betriebsfrequenz der Digitalschaltung bereitgestellt werden. Zum Beispiel kann bei synchronen DRAMs in jedem Taktzyklus eine neue Adresse angelegt werden.

Leider liegt die maximale Signalfrequenz der derzeit gebräuchlichen Testgeräte oder Testsysteme unter der maximal zulässigen Taktfrequenz neuester Hochfrequenzdigitalschaltungen, insbesondere Speicherbausteine.

Es ist Aufgabe der Erfindung, einen Adressgenerator so anzugeben, dass das bisher für den Produktionstest eingesetzte Testgerät, dessen Signalfrequenz wesentlich kleiner als die Betriebsfrequenz des zu testenden Bausteins ist, weiterhin für den Produktionstest von hochfrequenten Digitalschaltungen, insbesondere Speicherbausteinen so benutzt werden kann, dass die Adressierung mit der hohen Frequenz der Digitalschaltung durchgeführt werden kann.

Im vorgeschlagenen die obige Aufgabe lösenden Adresszähler erfolgt das Zählen der Adressen über eine Addition der Inhalte programmierbarer und/oder fester Offsetregister zu der jeweils vorliegenden Zeilen- und/oder Spaltenadresse. Der Eingang des Adresszählers wird vom Testgerät mit niedriger Frequenz angesteuert. Die Auswahl der Offsetregister übernimmt eine Auswahl- und Verknüpfungsschaltung, die durch Steuersignale hoher Frequenz angesteuert wird. Am Eingang des Adresszählers liegt ein Multiplexer, der aufgrund von vom Testgerät bereitgestellten m niederfrequenten Eingangssignalen n Steuersignale hoher Frequenz erzeugt. Der Faktor der Frequenzvervielfachung ergibt sich aus dem Verhältnis der Anzahl m der Eingänge zur Anzahl n der zur Auswahl der Offsetregister benötigten Steuersignale.

Mit Hilfe frei programmierbarer Offsetregister können sehr flexibel sowohl einfache Adressenwechsel (inkrementieren oder dekrementieren von Adressen) als auch Adressensprünge mit hoher Taktfrequenz realisiert werden.

Der vorgeschlagene Adresszähler ist bevorzugt als eine vom Testgerät separate Halbleiterschaltung realisiert, die zwischen dem Testgerät und der zu testenden Digitalschaltung (insbesondere dem Halbleiterspeicherbaustein) geschaltet wird. Somit können mit dem erfindungsgemäßen Adresszähler aus m vom Testgerät zur Verfügung gestellten Eingangssignalen niedriger Frequenz Adresssignale hoher Frequenz generiert werden.

Auf diese Weise läßt sich zur Generierung von Adresssignalen, die zur Ansteuerung hochfrequenter Digitalschaltungen, insbesondere Speicherbausteine benötigt werden, anstelle eines hochfrequenten und teuren Testsystems ein niederfrequentes Testsystem oder -gerät benutzen, dessen mit niedriger Frequenz zur Verfügung gestellte m Test-Adresssignale mit Multiplexern hochfrequent serialisiert werden.

Der erfindungsgemäße Adresszähler erspart den Ankauf neuer teurer Hochfrequenztestsysteme und vermeidet bei dem Test hochfrequenter Digitalschaltungen insbesondere von mit hoher Taktfrequenz betriebenen Speicherbausteinen das Risiko, dass Fehler unentdeckt bleiben, da die Digitalschaltungen bzw. Speicherbausteine mit der deren Spezifikation entsprechenden hohen Frequenz adressiert werden können.

Nachstehend wird ein Ausführungsbeispiel des erfindungsgemäßen Adresszählers anhand der blockschaltbildartigen Figur näher erläutert.

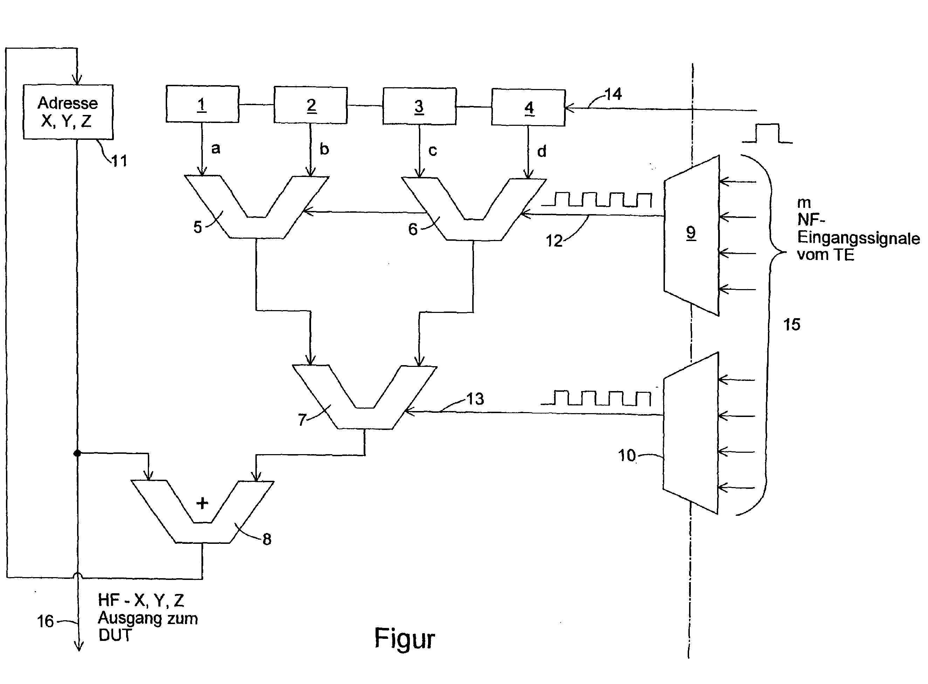

Der in der Figur gezeigte Adresszähler weist vier programmierbare Offsetregister 1, 2, 3 und 4 auf, in die zum Beispiel die Inhalte a, b, c und d gesetzt sind. Von einem Testgerät TE werden zur Auswahl der Inhalte a - d dieser vier Offsetregister 1 - 4 m, zum Beispiel acht parallele Eingangssignale 15 mit niedriger Frequenz zugeführt, die von jeweils einem 4 : 1 Multiplexer 9 und 10 in hochfrequente Steuersignale 12, 13 zur Ansteuerung einer aus Multiplexern 5, 6 und 7 bestehenden Auswahlschaltung umgesetzt werden, die die Ausgänge a, b, c und d der Offsetregister 1, 2, 3 und 4 empfängt. Der von den die Auswahlschaltung bildenden Multiplexern 5, 6 und 7 ausgewählte Adressenoffsetwert a, b, c oder d wird einem Eingang eines Verknüpfungsglieds 8 angelegt, das zum Beispiel ein Addierer ist. Der Addierer 8 empfängt an einem zweiten Eingang eine laufende Adresse x, y, z von einem Adressenregister 11 und addiert zur laufenden Adresse jeweils den aus einem der Offsetregister 1 - 4 stammenden Offsetwert a, b, c oder d. Der Ausgang des Adressenregisters 11 für die laufende Adresse bildet gleichzeitig den Hochfrequenz-Adressierausgang 16 zur zu testenden Digitalschaltung DUT, zum Beispiel zu einem zu testenden synchronen DRAM. Auf diese Weise können die mit dem Adresszähler erzeugten Adressensignale mit der Betriebsfrequenz der Digitalschaltung, insbesondere des Speicherbausteins bereitgestellt werden, obwohl die vom Testgerät TE stammenden niederfrequenten Eingangssignale 15 eine viermal geringere Frequenz haben.

Da die Offsetregister 1 - 4 bevorzugt frei programmierbar sind, können mit ihnen sehr flexibel sowohl einfache Adressenwechsel (sukzessives Hochzählen) als auch Adresssprünge mit hoher Taktfrequenz realisiert werden. Eine Programmierleitung 14 führt die in die Offsetregister 1 - 4 zu setzenden Daten, zum Beispiel vom Testgerät TE, zu.

Es ist zu bemerken, dass das in der Figur dargestellte Ausführungsbeispiel eines erfindungsgemäßen Adresszählers lediglich beispielshaft eine Frequenzvervierfachung und eine Auswahl aus vier Offsetregistern realisiert. Ein derartiger Adresszähler kann in Form einer Halbleiterschaltung realisiert werden, die zum Beispiel ein Teil eines zwischen einem Testgerät und einem Speicherbaustein geschalteten, vom Testgerät separaten, Halbleiterschaltkreises ist, auch BOST (Build Outside Self Test) genannt. Dieser kann mit dem erfindungsgemäßen Adresszähler bestehende Testgeräte, die nur eine unzureichende zeitliche Genauigkeit und im Vergleich mit den zu testenden Digitalbausteinen, insbesondere Speicherbausteinen, nur eine geringe Taktfrequenz haben, so "veredeln", dass damit eine sehr flexible und in der Reihenfolge beliebig programmierbare Adressengenerierung für die zu testenden Digitalschaltungen erreicht wird.

Nach dem oben Gesagten ermöglicht der erfindungsgemäße Adresszähler, dass ein preiswertes, bereits vorhandenes, niederfrequentes Testgerät für einen dennoch zuverlässigen Test durch Adressierung von hochfrequenten Digitalschaltungen verwendet werden kann.

## Patentansprüche

1. Adresszähler in Kombination mit einem Testgerät (TE) zur Adressierung und zum Test von synchronen hochfrequenten Digitalschaltungen, insbesondere Speicherbauelementen, der Spalten- und Zeilenadressen mit der Betriebsfrequenz der Digitalschaltung (DUT) erzeugt,
**dadurch gekennzeichnet, dass** der Adresszähler aufweist:
- n programmierbare und/oder feste Offsetregister (1 - 4) zur Speicherung von n Adressenoffsetwerten (a, b, c, d),
- eine mit den Ausgängen der Offsetregister (1 - 4) verbundene Auswahl- und Verknüpfungsschaltung (5 - 8) zur steuerbaren Auswahl der in den Offsetregistern (1 - 4) gespeicherten Adressenoffsetwerte (a, b, c, d) und Erzeugung von hochfrequenten Ausgangsadressen (16) für die zu testende Digitalschaltung (DUT) und
- eine die Auswahl- und Verknüpfungsschaltung (5 - 8) steuernde Steuerschaltung (9, 10), die von dem Testgerät (TE) m niederfrequente Eingangssignale (15) empfängt und daraus n hochfrequente Steuersignale (12, 13) für die Ansteuerung der Auswahl- und Verknüpfungsschaltung (5 - 8) und die Auswahl der Adressenoffsetwerte (a, b, c, d) der Offsetregister (1 - 4) erzeugt.

2. Adresszähler nach Anspruch 1,
**dadurch gekennzeichnet, dass** vier Offsetregister (1 - 4) und als die Steuerschaltung zwei (4 : 1)-Multiplexer (9, 10) zur Frequenzvervierfachung und Auswahl von vier in den Offsetregistern (1 - 4) gespeicherten Adressenoffsetwerten (a, b, c, d) vorgesehen sind.

3. Adresszähler nach Anspruch 1 oder 2,
**dadurch gekennzeichnet, dass** die m niederfrequenten Eingangssignale (15) vom Testgerät (TE) parallel bereitgestellt werden.

4. Adresszähler nach einem der vorangehenden Ansprüche,
**dadurch gekennzeichnet, dass** er als eine vom Testgerät (TE) separate Halbleiterschaltung realisiert ist, und dass die Offsetregister (1 - 4) vom Testgerät (TE) programmierbar bzw. ladbar sind.

5. Adresszähler nach einem der vorangehenden Ansprüche,
**dadurch gekennzeichnet, dass** er Teil eines zwischen das Testgerät (TE) und die zu testende Digitalschaltung geschalteten und dieser räumlich und funktionell zugeordneten Halbleiterschaltkreises (BOST) ist.

6. Verwendung des Adresszählers nach einem der vorangehenden Ansprüche für einen parallelen Test einer Anzahl hochfrequenter synchroner DRAM-Bausteine, wobei jedem DRAM-Baustein ein solcher Adresszähler zugeordnet ist und alle Adresszähler von demselben Testgerät (TE) angesteuert werden.
